# EUROPEAN PATENT APPLICATION

(11) **EP 4 148 860 A2**
(43) Date of publication of application: **15.03.2023**
(21) Application number: 22194294.9
(22) Date of filing: 07.09.2022
(51) Int. Cl.: H01M 10/42, H02J 7/00

(54) **ENERGY STORAGE SYSTEM AND PARAMETER CALIBRATION METHOD**

(30) Priority: 09.09.2021 CN 202111053869
(71) Applicant: Huawei Digital Power Technologies Co., Ltd., Shenzhen, 518043 (CN)
(72) Inventor: Li, Lin, Shenzhen, 518129 (CN); Zhou, He, Shenzhen, 518129 (CN); Guo, Haibin, Shenzhen, 518129 (CN)
(74) Representative: Thun, Clemens

(57) **Abstract**

An energy storage system and a parameter calibration method are provided. The energy storage system includes a control apparatus and one or more battery sub-arrays. Each battery sub-array includes one or more energy storage racks. Each energy storage rack includes one or more battery packs. The control apparatus is configured to: determine that parameter calibration needs to be performed on a first energy storage rack in a first battery sub-array; when the first energy storage rack meets a preset condition, increase a weight of the first energy storage rack in the first battery sub-array; and after each battery pack in the first energy storage rack is fully charged or remaining power of the battery pack is fully discharged, perform calibration on a parameter of the battery pack. Therefore, the energy storage rack may be fully charged or discharged in advance, to complete parameter calibration on each battery pack in the energy storage rack. This can effectively alleviate a problem that a battery parameter error increases over a long time, and help prolong a service life of the battery pack.

## Description

### TECHNICAL FIELD

This application relates to the field of battery management technologies, and more specifically, to an energy storage system and a parameter calibration method.

### BACKGROUND

With development of a new energy storage system, a battery parameter, for example, a state of charge (state of charge, SOC), is critical to system management. The SOC may be used for representing a percentage of a state of energy in the battery. If the SOC is inaccurate, a service life of the battery or allocation of a scheduling instruction may be affected. Therefore, it is necessary to calibrate battery parameters periodically.

Generally, parameter calibration on a battery needs to be performed when the battery reaches a state of full charge or discharge. At present, parameter calibration can be performed only when the battery passively reaches full charge or discharge. However, for some special scenarios, such as a scenario of frequent charge/discharge scheduling, the battery cannot reach a state of full charge or discharge for a long time. As a result, parameter calibration cannot be performed on the battery for a long time. An error may increase over a long time period, affecting a service life of the battery.

Therefore, how to perform parameter calibration on a battery that cannot reach a state of full charge or discharge for a long time is a problem that needs to be resolved urgently.

### SUMMARY

This application provides an energy storage system and a parameter calibration method, to fully charge or discharge an energy storage rack in advance before a new charge/discharge instruction arrives. In this way, parameter calibration on each battery pack in the energy storage rack is completed, and a service life of the battery pack is prolonged.

According to a first aspect, this application provides an energy storage system. The energy storage system includes a control apparatus and one or more battery sub-arrays. Each of the one or more battery sub-arrays includes one or more energy storage racks. Each of the one or more energy storage racks includes one or more battery packs. The control apparatus is configured to: determine that parameter calibration needs to be performed on a first energy storage rack in a first battery sub-array of the one or more battery sub-arrays; when the first energy storage rack meets a preset condition, increase a weight of the first energy storage rack in the first battery sub-array, where the weight is a weight of a charge power of the first energy storage rack in a charge state to a total charge power of the first battery sub-array, or a weight of a discharge power of the first energy storage rack in a discharge state to a total discharge power of the first battery sub-array; and after each battery pack in the first energy storage rack is fully charged or remaining power of the battery pack is fully discharged, perform calibration on a parameter of the battery pack.

Based on the foregoing technical solution, a charge speed or a discharge speed of the energy storage rack may be accelerated by increasing the weight of the energy storage rack in the battery sub-array, so that the energy storage rack can reach a state of fully charge or discharge in advance when no new charge/discharge instruction is received. Further, parameter calibration is performed on each battery pack in the energy storage rack, and increasing the weight of the energy storage rack in the battery sub-array does not affect allocation of a scheduling instruction. Therefore, the energy storage rack can reach a state of fully charge or discharge, and parameter calibration on each battery pack is completed. This can effectively alleviate a problem that a battery parameter error increases over a long time period, and help prolong a service life of the battery pack. In addition, the scheduling instruction of the system is not affected, and normal operation of the entire system is not affected.

It should be understood that whether to increase the weight of the first energy storage rack in the first battery sub-array may be further determined based on a status of the first energy storage rack.

In a possible case, the first energy storage rack is in a discharge state. When the first energy storage rack is in a discharge state, the preset condition includes: A percentage of a state of energy of the first energy storage rack is less than a first preset threshold; or a percentage of a state of energy of the first energy storage rack is greater than or equal to a first preset threshold, but the first energy storage rack receives a charge instruction; or a duration in which the first energy storage rack is in a discharge state is greater than a second preset threshold.

In another possible case, the first energy storage rack is in a charge state. When the first energy storage rack is in a charge state, the preset condition includes: A percentage of a state of energy of the first energy storage rack is greater than a third preset threshold; or a percentage of a state of energy of the first energy storage rack is less than or equal to a third preset threshold, but the first energy storage rack receives a discharge instruction; or a duration in which the first energy storage rack is in a charge state is greater than a fourth preset threshold.

Regardless of whether the first energy storage rack is in a charge state or a discharge state, the control apparatus may increase the weight of the first energy storage rack in the first battery sub-array when the first energy storage rack meets the preset condition. The preset condition in which the first energy storage rack is in different states are comprehensively considered, so that when the first energy storage rack does not receive a new charge/discharge instruction, the weight of the first energy storage rack in the first battery sub-array can be increased provided that the preset condition is met. In other words, the charge power or the discharge power of the first energy storage rack is accelerated, so that a state of fully charge or discharge can be reached in advance, and parameter calibration is performed on each battery pack in the energy storage rack.

There are two possible implementations in which the control apparatus is configured to increase the weight of the first energy storage rack in the first battery sub-array when the first energy storage rack meets the preset condition.

In a possible implementation, the control apparatus includes a sub-array control unit and one or more battery control units (battery control unit, BCU). Each BCU corresponds to an energy storage rack. A first BCU corresponding to the first energy storage rack is configured to determine that parameter calibration needs to be performed on the first energy storage rack, and is configured to send a calibration request to the sub-array control unit. The calibration request is used for requesting to perform parameter calibration on the first energy storage rack. In response to the calibration request, the sub-array control unit determines a first power adjustment value of the first energy storage rack when the first energy storage rack meets the preset condition, to increase the weight of the first energy storage rack in the first battery sub-array; and sends a first power adjustment instruction to the first BCU. The first power adjustment instruction carries the first power adjustment value.

The sub-array control unit is further configured to: when the first energy storage rack does not meet the preset condition, determine a second power adjustment value of the first energy storage rack, to reduce the weight of the first energy storage rack in the first battery sub-array; and send a second power adjustment instruction to the first BCU. The second power adjustment instruction carries the second power adjustment value.

In the foregoing technical solution, after determining that parameter calibration needs to be performed on the first energy storage rack, the first BCU corresponding to the first energy storage rack sends the calibration request to the sub-array control unit, to request to perform parameter calibration on the first energy storage rack. After receiving the calibration request, the sub-array control unit determines whether the first energy storage rack meets the preset condition, and when the first energy storage rack meets the preset condition, determines the first power adjustment value, to increase the weight of the first energy storage rack in the first battery sub-array, and when the first energy storage rack does not meet the preset condition, determines the second power adjustment value of the first energy storage rack, to reduce the weight of the first energy storage rack in the first battery sub-array. When the first energy storage rack meets the preset condition, a charge speed or a discharge speed of the first energy storage rack is accelerated by increasing the weight of the first energy storage rack in the first battery sub-array, so that the first energy storage rack reaches a state of fully charge or discharge in advance when no new charge/discharge instruction is received. In this way, a parameter of the first energy storage rack is calibrated. When the first energy storage rack does not meet the preset condition, a charge speed or a discharge speed of the first energy storage rack is slowed down by reducing the weight of the first energy storage rack in the first battery sub-array, so that the first energy storage rack can quickly reach a state of fully charge or discharge when a new charge/discharge instruction arrives. In this way, a parameter of the first energy storage rack is calibrated.

In another possible implementation, the control apparatus includes a sub-array control unit and one or more BCUs. Each BCU corresponds to an energy storage rack. A first BCU corresponding to the first energy storage rack is configured to determine that parameter calibration needs to be performed on the first energy storage rack, and is configured to: when the first energy storage rack meets the preset condition, send a first weight adjustment request to the sub-array control unit. The first weight adjustment request is used for requesting to increase the weight of the first energy storage rack in the first battery sub-array. The sub-array control unit determines a first power adjustment value of the first energy storage rack in response to the first weight adjustment request, to increase the weight of the first energy storage rack in the first battery sub-array; and sends a first power adjustment instruction to the first BCU. The first power adjustment instruction carries the first power adjustment value.

The first BCU is further configured to: when the first energy storage rack does not meet the preset condition, send a second weight adjustment request to the sub-array control unit. The second weight adjustment request is used for requesting to reduce the weight of the first energy storage rack in the first battery sub-array. The sub-array control unit determines a second power adjustment value of the first energy storage rack in response to the second weight adjustment request, to reduce the weight of the first energy storage rack in the first battery sub-array; and send a second power adjustment instruction to the first BCU. The second power adjustment instruction carries the second power adjustment value.

In the foregoing technical solution, after determining that parameter calibration needs to be performed, the first BCU corresponding to the first energy storage rack further determines whether the first energy storage rack meets the preset condition. When the first energy storage rack meets the preset condition, the first BCU sends the first weight adjustment request to the sub-array control unit, to request to increase the weight of the first energy storage rack in the first battery sub-array. When the first energy storage rack does not meet the preset condition, the first BCU sends the second weight adjustment request to the sub-array control unit, to request to reduce the weight of the first energy storage rack in the first battery sub-array. It may be understood that the first BCU may also determine whether the first energy storage rack meets the preset condition, and notify the sub-array control unit of how to adjust the weight of the first energy storage rack. When the first energy storage rack meets the preset condition, a charge speed or a discharge speed of the first energy storage rack is accelerated by increasing the weight of the first energy storage rack in the first battery sub-array, so that the first energy storage rack reaches a state of fully charge or discharge in advance when no new charge/discharge instruction is received. In this way, a parameter of the first energy storage rack is calibrated. When the first energy storage rack does not meet the preset condition, a charge speed or a discharge speed of the first energy storage rack is slowed down by reducing the weight of the first energy storage rack in the first battery sub-array, so that the first energy storage rack can quickly reach a state of fully charge or discharge when a new charge/discharge instruction arrives. In this way, a parameter of the first energy storage rack is calibrated.

With reference to the first aspect, in some possible implementations of the first aspect, the control apparatus further includes one or more battery monitor units (battery monitor unit, BMU). Each BMU corresponds to a battery pack. Each BMU corresponding to each battery pack in the first energy storage rack is configured to perform calibration on a parameter of the corresponding battery pack after the corresponding battery pack is fully charged or remaining power of the corresponding battery pack is fully discharged.

The weight of the first energy storage rack in the first battery sub-array is adjusted, so that after the first energy storage rack reaches a state of fully charge or discharge in advance, parameter calibration can be performed on each battery pack by using the BMU corresponding to each battery pack in the first energy storage rack. This can prolong a service life of the battery pack.

Optionally, a first BMU in the one or more BMUs is further configured to determine, based on one or more of the following items, that a parameter of a first battery pack in the first energy storage rack needs to be calibrated: An accumulated ampere-hour value is greater than or equal to a fifth preset threshold; or a time period since last parameter calibration is greater than or equal to a sixth preset threshold; or an accumulated charging energy value is greater than or equal to a seventh preset threshold; or an accumulated discharging energy value is greater than or equal to an eighth preset threshold.

When the BMU determines, based on one or more of the foregoing items, that parameter calibration needs to be performed on the battery pack, a plurality of possible determining manners are provided. If parameter calibration needs to be performed on any battery pack in the first energy storage rack, the first BCU corresponding to the first energy storage rack may determine that parameter calibration needs to be performed on the first energy storage rack. In other words, if parameter calibration needs to be performed on one battery pack in the first energy storage rack, parameter calibration on the one or more battery packs in the first energy storage rack may be triggered. This can prolong a service life of each battery pack in the first energy storage rack.

With reference to the first aspect, in some possible implementations of the first aspect, the control apparatus is further configured to determine a status of the first energy storage rack. The status includes a charge state or a discharge state.

The control apparatus determines the status of the first energy storage rack, to determine, based on the charge/discharge state, the preset condition, and the like of the first energy storage rack, how to adjust the weight of the first energy storage rack in the first battery sub-array. Therefore, the first energy storage rack can reach a state of fully charge or discharge in advance, and then parameter calibration is performed on each battery pack in the first energy storage rack.

According to a second aspect, this application provides a parameter calibration method, applied to the foregoing energy storage system. The method includes: determining that parameter calibration needs to be performed on a first energy storage rack, where the first energy storage rack is an energy storage rack in a first battery sub-array of one or more battery sub-arrays; when the first energy storage rack meets a preset condition, increasing a weight of the first energy storage rack in the first battery sub-array; and after each battery pack in the first energy storage rack is fully charged or remaining power of the battery pack is fully discharged, performing calibration on a parameter of the battery pack.

Based on the foregoing technical solution, when it is determined that parameter calibration needs to be performed on the first energy storage rack, a charge speed or a discharge speed of the energy storage rack may be accelerated by increasing the weight of the energy storage rack in the battery sub-array, so that the energy storage rack can reach a state of fully charge or discharge in advance when no new charge/discharge instruction is received. Further, parameter calibration is performed on each battery pack in the energy storage rack, and increasing the weight of the energy storage rack in the battery sub-array does not affect allocation of a scheduling instruction. Therefore, the energy storage rack can reach a state of fully charge or discharge, and parameter calibration on each battery pack is completed. This can effectively alleviate a problem that a battery parameter error increases over a long time period, and help prolong a service life of the battery pack. In addition, the scheduling instruction of the system is not affected, and normal operation of the entire system is not affected.

It should be understood that the first energy storage rack may be in a charge state or a discharge state, and preset conditions are different in different states. Therefore, the preset condition has the following two cases.

In a possible case, the first energy storage rack is in a discharge state. When the first energy storage rack is in a discharge state, the preset condition includes: A percentage of a state of energy of the first energy storage rack is less than a first preset threshold; or a percentage of a state of energy of the first energy storage rack is greater than or equal to a first preset threshold, but the first energy storage rack receives a charge instruction; or a duration in which the first energy storage rack is in a discharge state is greater than a second preset threshold.

In another possible case, the first energy storage rack is in a charge state. When the first energy storage rack is in a charge state, the preset condition includes: A percentage of a state of energy of the first energy storage rack is greater than a third preset threshold; or a percentage of a state of energy of the first energy storage rack is less than or equal to a third preset threshold, but the first energy storage rack receives a discharge instruction; or a duration in which the first energy storage rack is in a charge state is greater than a fourth preset threshold.

How to adjust the weight of the first energy storage rack in the first battery sub-array may be determined based on whether the first energy storage rack is in a charge state or a discharge state and with reference to a corresponding preset condition. When the first energy storage rack meets the preset condition, the weight of the first energy storage rack in the first battery sub-array is increased. A charge power or a discharge power of the first energy storage rack is accelerated by increasing the weight of the first energy storage rack, so that a state of fully charge or discharge can be reached in advance, and parameter calibration is performed on each battery pack in the energy storage rack.

With reference to the second aspect, in some possible implementations of the second aspect, the method further includes: when the first energy storage rack does not meet the preset condition, keeping a status of the first energy storage rack unchanged, and keeping the weight of the first energy storage rack in the plurality of energy storage racks unchanged; or keeping a status of the first energy storage rack unchanged, but reducing the weight of the first energy storage rack in the plurality of energy storage racks, until the first energy storage rack reaches the preset condition.

When the first energy storage rack does not meet the preset condition, a charge speed or a discharge speed of the first energy storage rack is slowed down by reducing the weight of the first energy storage rack in the first battery sub-array, so that the first energy storage rack can quickly reach a state of fully charge or discharge when a new charge/discharge instruction arrives. In this way, a parameter of the first energy storage rack is calibrated.

With reference to the second aspect, in some possible implementations of the second aspect, the method further includes: determining a status of the first energy storage rack. The status includes a charge state or a discharge state.

Optionally, the determining that a parameter of a first energy storage rack needs to be calibrated includes: when at least one of the following items is met, determining that the parameter of the first energy storage rack needs to be calibrated: An accumulated ampere-hour value is greater than or equal to a fifth preset threshold; or a time period since last parameter calibration is greater than or equal to a sixth preset threshold; or an accumulated charging energy value is greater than or equal to a seventh preset threshold; or an accumulated discharging energy value is greater than or equal to an eighth preset threshold.

Based on one or more of the foregoing items, it may be determined that parameter calibration needs to be performed on the battery pack, a plurality of possible determining manners are provided. If parameter calibration needs to be performed on any battery pack in the first energy storage rack, the first BCU corresponding to the first energy storage rack may determine that parameter calibration needs to be performed on the first energy storage rack. In other words, if parameter calibration needs to be performed on one battery pack in the first energy storage rack, parameter calibration on the one or more battery packs in the first energy storage rack may be triggered. This can prolong a service life of each battery pack in the first energy storage rack.

Optionally, the parameter of the first energy storage rack includes an SOC and/or a state of energy (state of energy, SOE).

According to a third aspect, this application provides a control apparatus, to implement the method in any one of the second aspect or the possible implementations of the second aspect. The apparatus includes a corresponding unit configured to perform the foregoing method. The units included in the apparatus may be implemented by using software and/or hardware.

According to a fourth aspect, this application provides a computer-readable storage medium. The computer storage medium stores a computer program (which may also be referred to as code or an instruction). When the computer program is run by a processor, the method according to any one of the second aspect or the possible implementations of the second aspect is performed.

According to a fifth aspect, this application provides a computer program product. The computer program product includes a computer program (which may also be referred to as code or an instruction). When the computer program is run, the method according to any one of the second aspect or the possible implementations of the second aspect is performed.

It should be understood that the third aspect to the fifth aspect of this application correspond to the technical solutions of the second aspect of this application, and beneficial effects achieved by the aspects and corresponding feasible implementations are similar. Details are not described again.

### BRIEF DESCRIPTION OF DRAWINGS

FIG. 1 is a schematic diagram of an architecture of an energy storage system according to an embodiment of this application;
FIG. 2 is a schematic diagram of a control apparatus according to an embodiment of this application;
FIG. 3 is a schematic flowchart of a parameter calibration method according to an embodiment of this application;
FIG. 4 is a schematic flowchart of determining whether parameter calibration needs to be performed on a battery pack according to an embodiment of this application;
FIG. 5 is a schematic flowchart of adjusting a weight of an energy storage rack in a battery sub-array according to an embodiment of this application;
FIG. 6 is a schematic flowchart of calibrating a battery pack according to an embodiment of this application; and
FIG. 7 is a schematic block diagram of a control apparatus according to an embodiment of this application.

### DESCRIPTION OF EMBODIMENTS

The following describes technical solutions of this application with reference to accompanying drawings.

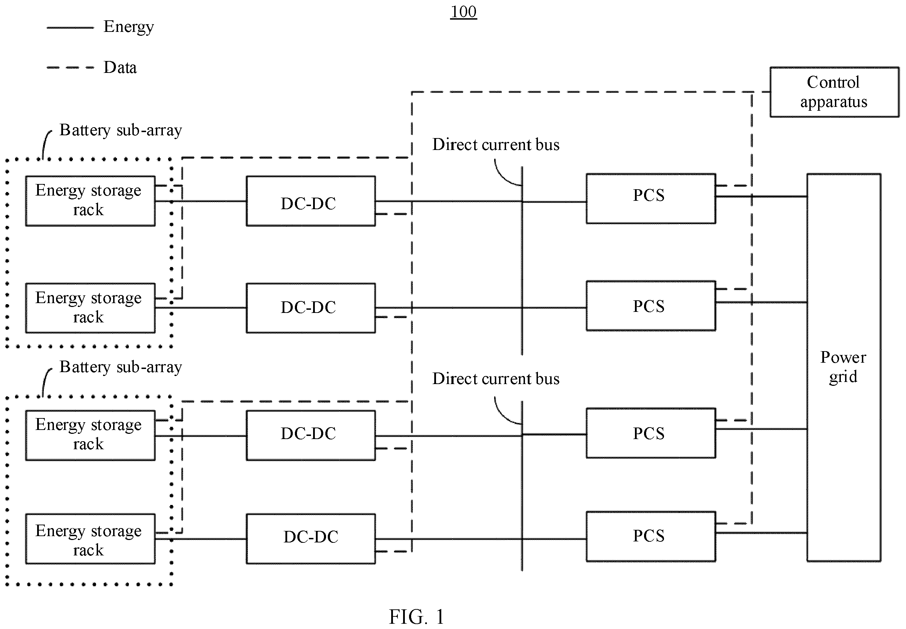

FIG. 1 is a schematic diagram of an architecture of an energy storage system 100 according to an embodiment of this application. The following first briefly describes an energy storage system provided in embodiments of this application with reference to FIG. 1.

As shown in FIG. 1, the energy storage system 100 includes a control apparatus and one or more battery sub-arrays. The control apparatus may be configured to control the one or more battery sub-arrays connected to the control apparatus. Each battery sub-array may include one or more energy storage racks. Each energy storage rack may include one or more battery packs.

Optionally, the energy storage system 100 further includes a direct current (direct current, DC)-DC converter, a power conversion system (power conversion system, PCS), and a direct current bus. The one or more battery sub-arrays may be connected to the DC bus through the DC-DC converter, and further connected to a power grid through the PCS to transmit electric energy to the power grid. The power grid may be any power supply network.

In the figure, for ease of differentiation, the energy is shown by using a solid line, and the data is shown by using a dashed line. It can be seen that a line connecting the battery sub-array to the power grid is a solid line, and is used for transmitting electric energy. A line connecting the control apparatus to each battery sub-array is a dashed line, and is used for transmitting data, such as a message or an instruction.

The control apparatus may exist in an independent physical form. For example, the control apparatus may be used as a general control unit to control each of the one or more battery sub-arrays connected to the control apparatus.

The control apparatus may also exist in a distributed physical form. For example, the control apparatus may be further divided into a smart sub-array control unit (smart sub array control unit, SACU) (sub-array control unit for short below), a BMU, and a BCU. The SACU is connected to one or more battery sub-arrays, and each of the one or more battery sub-arrays includes one or more energy storage racks. Each of the one or more energy storage racks includes one or more battery packs. Each energy storage rack is connected to a BCU and is controlled by the connected BCU. Each battery pack is connected to a BMU and is controlled by the connected BMU. In other words, each energy storage rack corresponds to a BCU, and each battery pack corresponds to a BMU. In addition, the BCU may be configured to manage and control one or more BMUs, and the sub-array control unit may be configured to manage and control one or more BCUs.

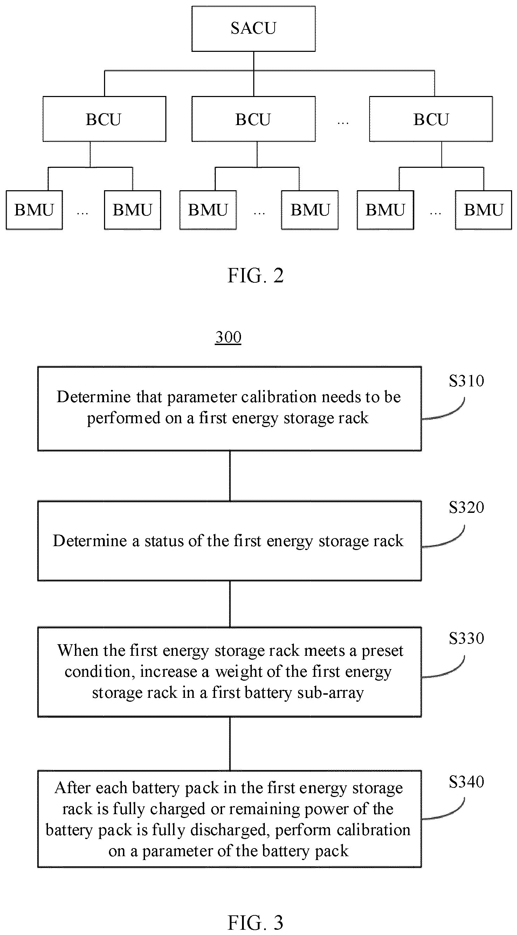

FIG. 2 shows an example of a control apparatus. As shown in FIG. 2, the control apparatus is further divided into an SACU, one or more BCUs, and one or more BMUs. The SACU is connected to the one or more BCUs, and each BCU is connected to the one or more BMUs. Each BMU is configured to monitor a voltage, a current, an SOC, and the like of a battery pack corresponding to the BMU, and may be further configured to perform status estimation, online diagnosis and warning, charge, discharge, and pre-charge control, balancing management, thermal management, and the like on the battery pack. Each BCU is configured to monitor the one or more BMUs connected to the BCU, for example, may be configured to monitor whether there is a message, an instruction, or the like from the BMU connected to the BCU, and may be further configured to monitor a voltage, a temperature, a current, and an insulation resistance of an energy storage rack, control a high-voltage direct current circuit relay and a state of health (state of health, SOH) of a battery group, estimate an SOC, and the like. The SACU is configured to control the one or more BCUs connected to the SACU, for example, may send a control instruction to the BCU.

It should be understood that the foregoing parts may be connected through a controller area network (controller area network, CAN) bus, a local interconnect network (local interconnect network, LIN) bus, a FlexRay (flex ray) bus, a medium oriented system transport (media oriented systems transport, MOST) bus, and the like. The foregoing types of buses may be configured to transmit information between the parts. For example, the BCU and the SACU may communicate with each other through a bus. It should be further understood that, forms or formats of signals transmitted on different buses connected to the foregoing different parts may be different, and a gateway may convert the signals in different forms or formats, and then send the converted signals to a signal receiver. Herein, the gateway is merely a name, and may also be replaced with another processor. The foregoing processor is configured to convert a format of a signal into a format required by the signal receiver.

It should be further understood that the schematic structure in this embodiment of this application does not constitute any limitation on an energy storage system 100. In some other embodiments, the energy storage system 100 may further include more or fewer components than those shown in the figure, or combine some components, or split some components, or have different component arrangements. The components shown in the figure may be implemented by hardware, software, or a combination of software and hardware.

For example, in some embodiments, the energy storage system 100 shown in FIG. 1 may further include an energy-based power generation system, a load, and the like. The energy-based power generation system may be a photovoltaic power generation system, a tidal power generation system, a wind power generation system, or the like. The load may be an electrical device such as a motor or a server.

In the energy storage system shown in FIG. 1, battery parameters (such as an SOC and an SOE) are critical to system management. For example, the SOC may be used for representing a percentage of a state of energy in a battery. If the SOC is inaccurate, a service life of the battery or allocation of a scheduling instruction may be affected. Therefore, it is necessary to calibrate battery parameters periodically.

Generally, parameter calibration on a battery needs to be performed when the battery reaches a state of full charge or discharge. At present, parameter calibration can be performed only when the battery passively reaches full charge or discharge. However, for some special scenarios, such as a scenario of frequent charge/discharge scheduling, the battery cannot reach a state of full charge or discharge for a long time. As a result, parameter calibration cannot be performed on the battery for a long time.

Therefore, this application provides an energy storage system and a parameter calibration method for an energy storage rack. When any battery pack in the energy storage rack has a parameter calibration requirement, a charge speed or a discharge speed of the energy storage rack may be accelerated by adjusting a weight of the energy storage rack in a battery sub-array, so that a battery pack in the energy storage rack can be fully charged or discharged in advance when no new charge/discharge instruction is received. In this way, parameter calibration is performed on each battery pack in the energy storage rack. Therefore, the energy storage rack may be fully charged or discharged in advance without affecting allocation of the scheduling instruction. In this way, parameter calibration on each battery pack in the energy storage rack is completed, and a service life of the battery pack is prolonged.

With reference to the accompanying drawings, the following describes in detail an energy storage system and a parameter calibration method for an energy storage rack that are provided in embodiments of this application.

The energy storage system may be, for example, the energy storage system shown in FIG. 1. For ease of understanding and description, in the following, an energy storage rack on which parameter calibration needs to be performed in the energy storage system is denoted as a first energy storage rack, and a battery sub-array in which the first energy storage rack is located is denoted as a first battery sub-array. It should be understood that the first battery sub-array may be any one of one or more battery sub-arrays in the energy storage system, and the first energy storage rack may be any one of one or more energy storage racks in the first battery sub-array. The first energy storage rack includes one or more battery packs. If parameter calibration needs to be performed on any one or more battery packs of the first energy storage rack, parameter calibration needs to be performed on the first energy storage rack.

It should be noted that, to clearly describe the technical solutions in embodiments of this application, terms such as "first" and "second" are used in embodiments of this application to distinguish between same items or similar items that have basically same functions and purposes. For example, a first power adjustment instruction and a second power adjustment instruction are used to distinguish between a power adjustment instruction when a preset condition is met and a power adjustment instruction when the preset condition is not met, and a sequence of the first power adjustment instruction and the second power adjustment instruction is not limited. A person skilled in the art may understand that the terms such as "first" and "second" do not limit a quantity or an execution sequence, and the terms such as "first" and "second" do not indicate a definite difference.

In this embodiment of this application, the control apparatus in the energy storage system may be configured to: determine that parameter calibration needs to be performed on the first energy storage rack in the first battery sub-array of the one or more battery sub-arrays connected to the control apparatus; may be configured to: when the first energy storage rack meets the preset condition, increase a weight of the first energy storage rack in the first battery sub-array; and may be further configured to: after each battery pack in the first energy storage rack is fully charged or remaining power of the battery pack is fully discharged, perform calibration on a parameter of the battery pack.

If the control apparatus exists in a distributed physical form, the control apparatus is further divided into an SACU, a BCU, and a BMU, and functions implemented by parts of the control apparatus are as follows.

The BMU may be configured to determine whether each battery pack in the first energy storage rack has a parameter calibration request, and may be further configured to: after each battery pack in the first energy storage rack is fully charged or the remaining power of the battery pack is fully discharged, performing calibration on the parameter of the battery pack.

The BCU may be configured to: determine whether parameter calibration needs to be performed on the first energy storage rack, and may be further configured to: when parameter calibration needs to be performed on the first energy storage rack, send the calibration request to the SACU. In this way, when the first energy storage rack meets the preset condition, the SACU increases the weight of the first energy storage rack in the first battery sub-array. In addition, in some embodiments, the BCU may be further configured to: when parameter calibration needs to be performed on the first energy storage rack, send a weight adjustment request to the SACU, to request to adjust the weight of the first energy storage rack in the first battery sub-array. For example, when parameter calibration needs to be performed on the first energy storage rack and the first energy storage rack meets the preset condition, a first weight adjustment request is sent to the SACU, to request to increase the weight of the first energy storage rack in the first battery sub-array. For another example, when parameter calibration needs to be performed on the first energy storage rack but the first energy storage rack does not meet the preset condition, a second weight adjustment request is sent to the SACU, to request to reduce the weight of the first energy storage rack in the first battery sub-array.

The SACU may be configured to: when the first energy storage rack meets the preset condition, increase the weight of the first energy storage rack in the first battery sub-array.

Optionally, a parameter of the energy storage rack includes an SOC or an SOE. The SOC may be used for representing a percentage of a state of energy in a battery. A value of the SOC may range from 0% to 100%. When the SOC is 0%, it may indicate that the battery is fully discharged. When the SOC is 100%, it may indicate that the battery is fully charged. The SOE may be used for representing a state of energy in the battery.

To better understand functions of the control apparatus in the energy storage system, the following describes in detail a parameter calibration method for an energy storage rack provided in an embodiment of this application with reference to FIG. 3 to FIG. 6.

FIG. 3 is a schematic flowchart of a parameter calibration method 300 according to an embodiment of this application. The method 300 shown in FIG. 3 may include S310 to S340. The following describes each step in FIG. 3 in detail.

S310: A control apparatus determines that parameter calibration needs to be performed on a first energy storage rack.

As described above, the control apparatus may include an SACU, one or more BCUs, and one or more BMUs. That a control apparatus determines that parameter calibration needs to be performed on a first energy storage rack may specifically include: A first BCU corresponding to the first energy storage rack determines whether parameter calibration needs to be performed on the first energy storage rack.

In a possible design, a BMU corresponding to each battery pack in the first energy storage rack may determine whether parameter calibration needs to be performed on each battery pack. When parameter calibration needs to be performed on at least one battery pack, the first BCU may determine that parameter calibration needs to be performed on the first energy storage rack. For example, when determining that parameter calibration needs to be performed on a battery pack corresponding to a first BMU, the first BMU sends a calibration request to the first BCU. The first BMU is any one of the one or more BMUs in the first energy storage rack. After receiving the calibration request, the first BCU determines that parameter calibration needs to be performed on the first energy storage rack.

The following uses the first BMU as an example to describe in detail how the BMU determines whether parameter calibration needs to be performed on the battery pack.

Optionally, the first BMU may determine, based on one or more of the following items, that parameter calibration needs to be performed on a first battery pack corresponding to the first BMU in the first energy storage rack: An accumulated ampere-hour value is greater than or equal to a fifth preset threshold; or a time period since last parameter calibration is greater than or equal to a sixth preset threshold; or an accumulated charging energy value is greater than or equal to a seventh preset threshold; or an accumulated discharging energy value is greater than or equal to an eighth preset threshold.

In an example, on a basis that the accumulated ampere-hour value is greater than or equal to the fifth preset threshold, the first BMU determines that parameter calibration needs to be performed on the first battery pack. The accumulated ampere-hour value is an accumulated value of a product of a current and a duration starting from last parameter calibration performed on the first battery pack, and the first battery pack is a battery pack corresponding to the first BMU. Specifically, when determining that the accumulated ampere-hour value is greater than or equal to the fifth preset threshold, the first BMU determines that parameter calibration needs to be performed on the first battery pack, and sends a parameter calibration request to the first BCU. Further, the first BCU determines that parameter calibration needs to be performed on the first energy storage rack. When the accumulated ampere-hour value is less than the fifth preset threshold, the first BCU determines that parameter calibration does not need to be performed on the first battery pack. That is, the parameter calibration request does not need to be sent to the first BCU.

In another example, on a basis that the accumulated ampere-hour value is greater than or equal to the fifth preset threshold and the time period since last parameter calibration is greater than or equal to the sixth preset threshold, the first BMU determines that parameter calibration needs to be performed on the first battery pack.

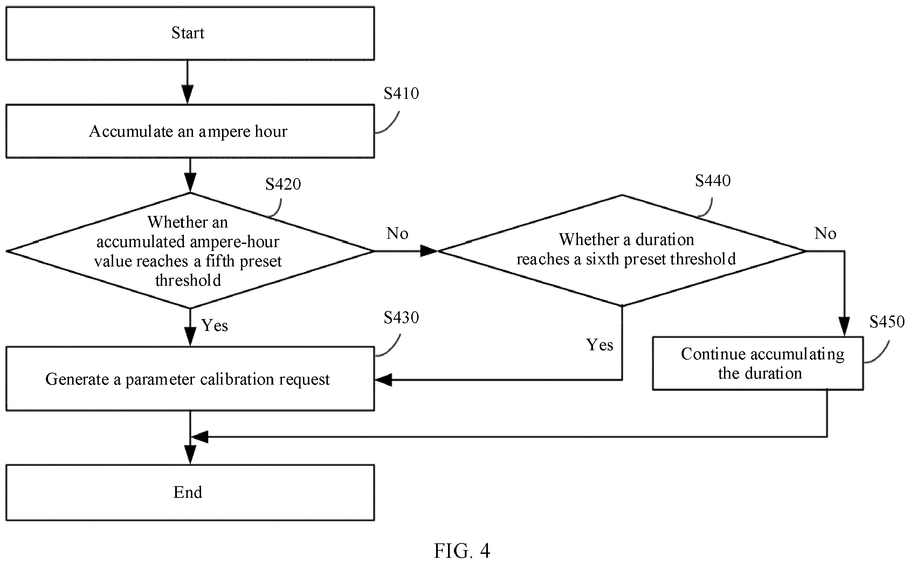

FIG. 4 shows a procedure in which the first BMU determines whether parameter calibration needs to be performed on the first battery pack. As shown in FIG. 4, the first BMU performs S410, to accumulate an ampere hour of the first battery pack. For example, if a discharge time of the first battery pack is 10 hours, and a discharge current is 3 amperes, the accumulated ampere-hour value is 10 × 3 = 30 ampere-hours. Further, the first BMU performs S420 to determine whether the accumulated ampere-hour value reaches the fifth preset threshold. If the accumulated ampere-hour value reaches the fifth preset threshold, the first BMU performs S430 to generate the parameter calibration request, and there is no need to continue to perform S440 and S450, and the procedure directly ends. If the accumulated ampere-hour value does not reach the fifth preset threshold, S440 is performed to determine whether the duration reaches the sixth preset threshold. The duration starts from a time when last parameter calibration is performed on the first battery pack, that is, whether the time period since last parameter calibration reaches the sixth preset threshold. If the duration reaches the sixth preset threshold, S430 is performed; or if the duration does not reach the sixth preset threshold, S450 is performed, to continue accumulating the time period since last parameter calibration until the end.

It should be understood that a sequence of S420 and S440 may be exchanged. To be specific, whether the time period since last parameter calibration reaches the sixth preset threshold is first determined, and then whether the accumulated ampere-hour value reaches the fifth preset threshold is further determined. This is not limited in this embodiment of this application.

Alternatively, on a basis that the accumulated charging energy value is greater than or equal to the seventh preset threshold, the first BMU may further determine that parameter calibration needs to be performed on the first battery pack; or on a basis that the accumulated discharging energy value is greater than or equal to the eighth preset threshold, determine that parameter calibration needs to be performed on the first battery pack; or on a basis that the accumulated charging energy value is greater than or equal to the seventh preset threshold and that the time period since last parameter calibration is greater than or equal to the sixth preset threshold, determine that parameter calibration needs to be performed on the first battery pack, or the like. For brevity, details are not described herein again one by one.

S320: The control apparatus determines a status of the first energy storage rack.

The status of the first energy storage rack includes a charge state or a discharge state. The control apparatus may determine whether the first energy storage rack is in a charge state or a discharge state.

In a possible implementation, the first BCU determines the status of the first energy storage rack. Specifically, after determining that parameter calibration needs to be performed on the first energy storage rack, the first BCU may further determine the status of the first energy storage rack.

In another possible implementation, the SACU determines the status of the first energy storage rack. Specifically, after determining that parameter calibration needs to be performed on the first energy storage rack, the first BCU may send the parameter calibration request to the SACU. The parameter calibration request is used for requesting to perform parameter calibration on the first energy storage rack. After receiving the calibration request, the SACU may determine whether the first energy storage rack is in a charge state or a discharge state.

S330: When the first energy storage rack meets a preset condition, the control apparatus increases a weight of the first energy storage rack in a first battery sub-array.

As described above, the status of the first energy storage rack includes a charge state or a discharge state. The weight of the first energy storage rack in the first battery sub-array may be understood as follows: If the first energy storage rack is in a charge state, the weight of the first energy storage rack in the first battery sub-array may be specifically a weight of a charge power of the first energy storage rack to a total charge power of the first battery sub-array; if the first energy storage rack is in a discharge state, the weight of the first energy storage rack in the first battery sub-array may be specifically a weight of a discharge power of the first energy storage rack to a total discharge power of the first battery sub-array.

Increasing the weight of the first energy storage rack in the first battery sub-array means that the charge power of the first energy storage rack is increased when the first energy storage rack is in a charge state, so that the weight of the charge power of the first energy storage rack to the total charge power of the first battery sub-array is increased; or the discharge power of the first energy storage rack is increased when the first energy storage rack is in a discharge state, so that the weight of the discharge power of the first energy storage rack to the total discharge power of the first battery sub-array is increased.

In this embodiment of this application, whether to increase the weight of the first energy storage rack in the first battery sub-array may be determined with reference to information such as the status and a state of energy of the first energy storage rack. When the first energy storage rack meets the preset condition, the control apparatus may increase the weight of the first energy storage rack in the first battery sub-array.

In a possible case, the first energy storage rack is in a discharge state, and the preset condition includes: A percentage of a state of energy of the first energy storage rack is less than a first preset threshold; or a percentage of a state of energy of the first energy storage rack is greater than or equal to a first preset threshold, but the first energy storage rack receives a charge instruction; or a duration in which the first energy storage rack is in a discharge state is greater than a second preset threshold.

In another possible case, the first energy storage rack is in a charge state, and the preset condition includes: A percentage of a state of energy of the first energy storage rack is greater than a third preset threshold; or a percentage of a state of energy of the first energy storage rack is less than or equal to a third preset threshold, but the first energy storage rack receives a discharge instruction; or a duration in which the first energy storage rack is in a charge state is greater than a fourth preset threshold.

It should be understood that the duration (that is, a discharge duration) in which the first energy storage rack is in a discharge state may be accumulated when the percentage of the state of energy of the first energy storage rack is greater than or equal to the first preset threshold, and the duration (that is, a charge duration) in which the first energy storage rack is in a charge state may be accumulated when the percentage of the state of energy of the first energy storage rack is less than or equal to the first preset threshold.

It should be further understood that a relationship between the percentage of the state of energy and the first preset threshold in the foregoing preset condition may also be converted into a relationship between the state of energy and the first preset threshold. For example, the first energy storage rack is in a discharge state, and the preset condition may be converted to: The state of energy of the first energy storage rack is less than the first preset threshold; or the state of energy of the first energy storage rack is greater than or equal to the first preset threshold, but the first energy storage rack receives the charge instruction; or the duration in which the first energy storage rack in a discharge state is greater than the second preset threshold.

In this way, if the first energy storage rack is in a discharge state and has a low state of energy, when no new charge instruction is received, the weight of the first energy storage rack in the first battery sub-array may be increased, so that the state of energy is fully discharged in advance; if the first energy storage rack is in a charge state and has a high state of energy, when no new discharge instruction is received, the weight of the first energy storage rack in the first battery sub-array may be increased, so that the first energy storage rack is fully charged in advance.

The following describes in detail a specific implementation of S330.

In a first possible implementation, the first BCU determines whether the first energy storage rack meets the preset condition, and sends a weight adjustment request to the SACU based on a determining result, to request the SACU to adjust the weight of the first energy storage rack in the first battery sub-array. In other words, the first BCU determines, based on the preset condition, how to adjust the weight of the first energy storage rack in the first battery sub-array, and then sends the weight adjustment request to the SACU. Specifically, after determining that parameter calibration needs to be performed on the first energy storage rack, the first BCU determines the status of the first energy storage rack, and when the first energy storage rack meets the preset condition, sends a first weight adjustment request to the SACU. The first weight adjustment request is used for requesting to increase the weight of the first energy storage rack in the first battery sub-array. The SACU determines a first power adjustment value of the first energy storage rack in response to the first weight adjustment request, to increase the weight of the first energy storage rack in the first battery sub-array; and sends a first power adjustment instruction to the first BCU. The first power adjustment instruction carries the first power adjustment value. In this way, a power of the first energy storage rack is adjusted to accelerate the first energy storage rack to reach a state of fully charge or discharge.

For example, when the power of the first energy storage rack is 200 watts (W), the first energy storage rack is currently in a discharge state, and the first energy storage rack meets the preset condition, the first BCU sends the first weight adjustment request to the SACU. In response to the first weight adjustment request, the SACU may determine that the first power adjustment value of the first energy storage rack is 20 W. In this case, the adjusted power of the first energy storage rack is 220 W. That is, the discharge power of the first energy storage rack is increased, and a discharge speed of the first energy storage rack is accelerated, so that the first energy storage rack reaches a state of fully discharge more quickly.

When the first energy storage rack does not meet the preset condition, the first BCU sends a second weight adjustment request to the SACU, to request the SACU to reduce the weight of the first energy storage rack in the first battery sub-array. The SACU determines a second power adjustment value of the first energy storage rack in response to the second weight adjustment request, to reduce the weight of the first energy storage rack in the first battery sub-array; and sends a second power adjustment instruction to the first BCU. The second power adjustment instruction carries the second power adjustment value. Alternatively, when the first energy storage rack does not meet the preset condition, the first BCU determines to remain the weight of the first energy storage rack in the first battery sub-array unchanged, that is, does not need to send the weight adjustment request to the SACU.

For example, when the power of the first energy storage rack is 200 W, the first energy storage rack is currently in a discharge state, and the first energy storage rack does not meet the preset condition, the first BCU sends the second weight adjustment request to the SACU. In response to the second weight adjustment request, the SACU determines that the power adjustment value of first energy storage rack is -20 W. In this case, the adjusted power of the first energy storage rack is 180 W. The discharge power of the first energy storage rack is reduced, and the discharge speed of the first energy storage rack is slowed down. In other words, battery energy of the first energy storage rack may approach zero more slowly, and when the charge instruction arrives, the first energy storage rack may reach a state of fully charge as soon as possible.

In a second possible implementation, the SACU determines whether the first energy storage rack meets the preset condition, and adjusts the weight of the first energy storage rack in the first battery sub-array based on a determining result. Specifically, after determining that parameter calibration needs to be performed on the first energy storage rack, the first BCU sends a calibration request to the SACU. The SACU determines a status of the first energy storage rack in response to the calibration request, and when the first energy storage rack meets the preset condition, determines a first power adjustment value of the first energy storage rack, to increase the weight of the first energy storage rack in the first battery sub-array; and sends a first power adjustment instruction to the first BCU. The first power adjustment instruction carries the first power adjustment value. After receiving the first power adjustment instruction, the first energy storage rack increases a power of the first energy storage rack based on the first power adjustment value, to accelerate the first energy storage rack to reach a state of fully charge or discharge.

When the first energy storage rack does not meet the preset condition, the SACU may determine a second power adjustment value of the first energy storage rack, to reduce the weight of the first energy storage rack in the first battery sub-array; and send a second power adjustment instruction to the first BCU. The second power adjustment instruction carries the second power adjustment value. Alternatively, when the first energy storage rack does not meet the preset condition, the SACU may also maintain the weight of the first energy storage rack in the first battery sub-array, that is, does not need to send an instruction for adjusting the power value to the first BCU.

It should be understood that the first power adjustment instruction and the second power adjustment instruction are used to distinguish between different power adjustment instructions, and do not constitute any limitation on a sequence of sending the first power adjustment instruction and the second power adjustment instruction.

The following uses the SACU as an example to describe in detail a procedure in which the SACU adjusts the weight of the first energy storage rack in the first battery sub-array with reference to the preset condition listed above. It should be understood that the first BCU may also determine, with reference to the preset condition, how to adjust the weight of the first energy storage rack in the first battery sub-array. A specific procedure is the same as that of the SACU.

Optionally, when the first energy storage rack is in a discharge state, the preset condition includes: A percentage of a state of energy of the first energy storage rack is less than a first preset threshold; or a percentage of a state of energy of the first energy storage rack is greater than or equal to a first preset threshold, but the first energy storage rack receives a charge instruction; or a duration in which the first energy storage rack is in a discharge state is greater than a second preset threshold.

For example, when the first energy storage rack is in a discharge state, assuming that a value of the first preset threshold is 50%, and a value of the second preset threshold is 5 minutes, when an SOC of the first energy storage rack is less than 50%, the SACU determines the first power adjustment value of the first energy storage rack, to increase the weight of the first energy storage rack in the first battery sub-array. This can accelerate the first energy storage rack to reach a state of fully discharge.

For another example, if the SOC of the first energy storage rack is greater than or equal to 50%, the weight of the first energy storage rack in the first battery sub-array may remain unchanged, and the SACU continues to wait for 5 minutes. If no charge instruction is received, that is, the duration in which the first energy storage rack is in a discharge state is greater than the second preset threshold, the SACU determines the first power adjustment value of the first energy storage rack, to increase the weight of the first energy storage rack in the first battery sub-array. This can accelerate the first energy storage rack to reach a state of fully discharge.

For another example, if the SOC of the first energy storage rack is greater than or equal to 50%, but the first energy storage rack receives the charge instruction, the SACU determines the first power adjustment value of the first energy storage rack, to increase the weight of the first energy storage rack in the first battery sub-array. In this case, the first energy storage rack is in a charge state, and the weight of the first energy storage rack in the first battery sub-array is increased. This can accelerate the first energy storage rack to reach a state of fully charge.

When the first energy storage rack is in a charge state, the preset condition includes: A percentage of a state of energy of the first energy storage rack is greater than a third preset threshold; or a percentage of a state of energy of the first energy storage rack is less than or equal to a third preset threshold, but the first energy storage rack receives a discharge instruction; or a duration in which the first energy storage rack is in a charge state is greater than a fourth preset threshold.

It should be understood that 50% and 5 minutes listed above are examples of the first preset threshold, the third preset threshold, the second preset threshold, and the fourth preset threshold respectively, and shall not constitute any limitation on this embodiment of this application. Specific values of the first preset threshold, the third preset threshold, the second preset threshold, and the fourth preset threshold are not limited in this embodiment of this application.

It should be further understood that values of the first preset threshold and the third preset threshold may be the same or may be different. Similarly, values of the second preset threshold and the fourth preset threshold may be the same or may be different. This is not limited in this embodiment of this application.

For example, when the first energy storage rack is in a charge state, assuming that a value of the third preset threshold is 50%, and a value of the fourth preset threshold is 5 minutes, it may be learned that values of the first preset threshold and the third preset threshold are the same, and values of the second preset threshold and the fourth preset threshold are the same. When the SOC of the first energy storage rack is greater than 50%, the SACU determines the first power adjustment value of the first energy storage rack, to increase the weight of the first energy storage rack in the first battery sub-array. This can accelerate the first energy storage rack to reach a state of fully charge.

For another example, if the SOC of the first energy storage rack is less than or equal to 50%, the weight of the first energy storage rack in the first battery sub-array may remain unchanged, and the SACU continues to wait for 5 minutes. If no discharge instruction is received, that is, the duration in which the first energy storage rack is in a charge state is greater than the fourth preset threshold, the SACU determines the first power adjustment value of the first energy storage rack, to increase the weight of the first energy storage rack in the first battery sub-array. This can accelerate the first energy storage rack to reach a state of fully charge.

For another example, if the SOC of the first energy storage rack is less than or equal to 50%, but the first energy storage rack receives the discharge instruction, the SACU determines the first power adjustment value of the first energy storage rack, to increase the weight of the first energy storage rack in the first battery sub-array. In this case, the first energy storage rack is in a discharge state, and the weight of the first energy storage rack in the first battery sub-array is increased. This can accelerate the first energy storage rack to reach a state of fully discharge.

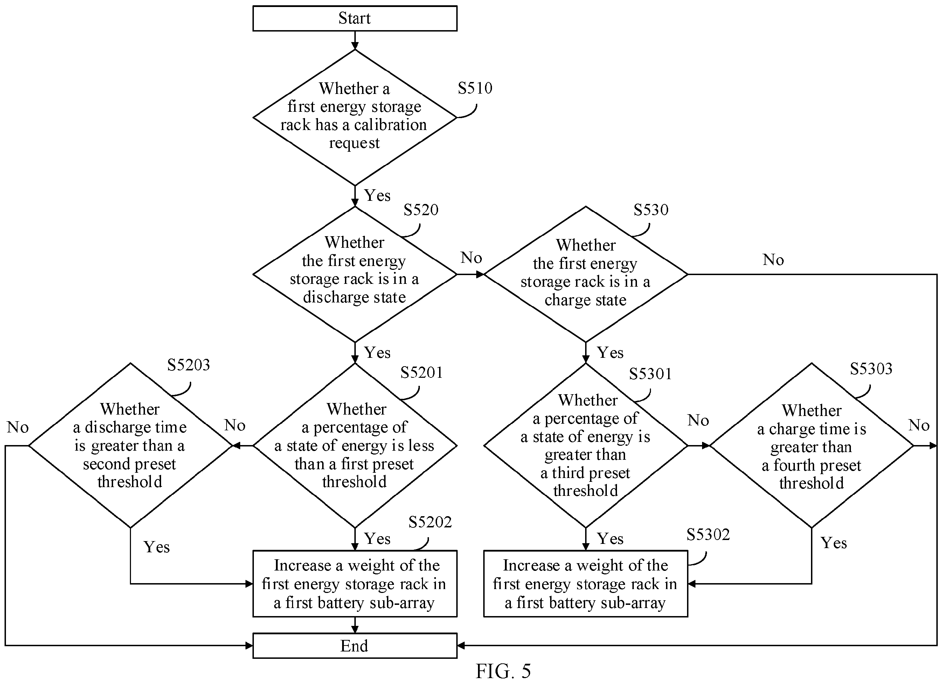

FIG. 5 shows an example of a specific procedure of S330.

As shown in FIG. 5, the SACU performs S510, to determine whether the first energy storage rack has a calibration request. If the SACU does not receive a calibration request from the first BCU, it is determined that the first energy storage rack has no calibration request, and the following steps do not need to be performed, and the procedure directly ends. If the SACU receives a calibration request from the first BCU, it is determined that the first energy storage rack has the calibration request, and S520 is further performed to determine whether the first energy storage rack is in a discharge state. If the first energy storage rack is not in a discharge state, S530 is further performed to determine whether the first energy storage rack is in a charge state.

It should be understood that S520 and S530 shown in FIG. 5 are merely an example, and are merely used for determining the status of the first energy storage rack. In some embodiments, S530 may be first performed to determine whether the first energy storage rack is in a charge state, and if not, S520 is then performed to determine whether the first energy storage rack is in a discharge state. Alternatively, the SACU may directly determine the status of the first energy storage rack. This is not limited in this embodiment of this application.

When determining that the first energy storage rack is in a discharge state, the SACU performs S5201 to determine whether the percentage of the state of energy of the first energy storage rack is less than the first preset threshold. If yes, S5202 of increasing the weight of the first energy storage rack in the first battery sub-array is performed. Specifically, the SACU determines the first power adjustment value, and sends the first power adjustment instruction to the first BCU, to increase the discharge power of the first energy storage rack. Increasing the discharge power accelerates the discharge speed of the first energy storage rack, so that the first energy storage rack reaches a state of fully discharge as soon as possible. If not, the weight of the first energy storage rack in the first battery sub-array remains unchanged, the first energy storage rack continues to perform discharge, and S5203 is further performed to determine whether the discharge time reaches the second preset threshold. If the discharge duration reaches the second preset threshold, but the charge instruction is still not received, S5202 is performed to increase the weight of the first energy storage rack in the first battery sub-array. If the discharge time is less than or equal to the second preset threshold, that is, the charge instruction is received, S5301 is performed.

When determining that the first energy storage rack is in a charge state, the SACU performs S5301 to determine whether the percentage of the state of energy of the first energy storage rack is greater than the third preset threshold. If yes, S5302 of increasing the weight of the first energy storage rack in the first battery sub-array is performed. Specifically, the SACU determines the first power adjustment value, and sends the first power adjustment instruction to the first BCU, so that the charge power of the first energy storage rack is increased, and the first energy storage rack reaches a state of fully charge as soon as possible. If not, the weight of the first energy storage rack in the first battery sub-array remains unchanged, the first energy storage rack continues to perform charge, and S5303 is further performed to determine whether the charge time reaches the fourth preset threshold. If the charge duration reaches the fourth preset threshold, but the discharge instruction is still not received, S5302 is performed. If the charge time is less than or equal to the fourth preset threshold, or in other words, the discharge instruction is received in the charging process, S5201 is performed.

S340: After each battery pack in the first energy storage rack is fully charged or remaining power of the battery pack is fully discharged, the control apparatus performs calibration on a parameter of the battery pack.

The BMU in the control apparatus may be configured to monitor a power status of each battery pack. When each battery pack in the first energy storage rack reaches a state of full charge or discharge, the BMU performs calibration on the parameter of each battery pack.

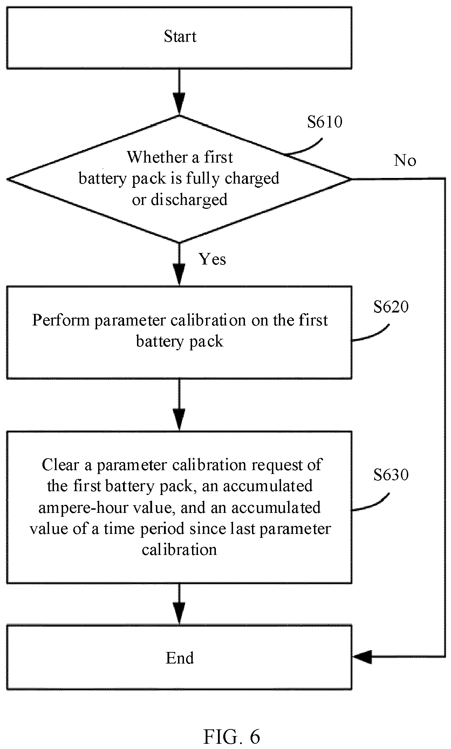

For example, the first BMU performs calibration on a parameter of the first battery pack when determining that the first battery pack reaches a state of full charge or discharge. Specifically, as shown in FIG. 6, the first BMU performs S610 of determining whether the first battery pack is in a state of full charge or discharge. If not, the procedure directly ends. If yes, S620 of performing parameter calibration on the first battery pack is further performed. After calibration is completed, S630 is performed to clear the parameter calibration request, the accumulated ampere-hour value, and the accumulated value of the time period since last parameter calibration. For a specific parameter calibration process, refer to an existing parameter calibration technology. Details are not described herein again.

Based on the foregoing technical solution, when it is determined that parameter calibration needs to be performed on an energy storage rack, a charge speed or a discharge speed of the energy storage rack may be accelerated by increasing a weight of the energy storage rack in a battery sub-array, so that the energy storage rack can reach a state of fully charge or discharge in advance when no new charge/discharge instruction is received. Further, parameter calibration is performed on each battery pack in the energy storage rack, and increasing the weight of the energy storage rack in the battery sub-array does not affect allocation of a scheduling instruction. Therefore, the energy storage rack can reach a state of fully charge or discharge, and parameter calibration on each battery pack is completed. This can effectively alleviate a problem that a battery parameter error increases over a long time, and help prolong a service life of the battery pack. In addition, the scheduling instruction of the system is not affected, and normal operation of the entire system is not affected.

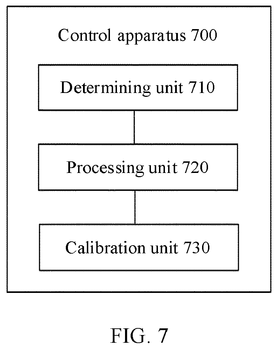

The following describes in detail a control apparatus provided in an embodiment of this application with reference to FIG. 7.

FIG. 7 is a schematic block diagram of a control apparatus 700 according to an embodiment of this application. As shown in FIG. 7, the apparatus 700 may include a determining unit 710, a processing unit 720, and a calibration unit 730.

The determining unit 710 may be configured to: determine that parameter calibration needs to be performed on a first energy storage rack. The first energy storage rack is an energy storage rack in a first battery sub-array of one or more battery sub-arrays. The processing unit 720 may be configured to: when the first energy storage rack meets a preset condition, increase a weight of the first energy storage rack in the first battery sub-array. The calibration unit 730 may be configured to: after each battery pack in the first energy storage rack is fully charged or remaining power of the battery pack is fully discharged, perform calibration on a parameter of the battery pack.

Optionally, the determining unit 710 may be further configured to: determine a status of the first energy storage rack. The status includes a charge state or a discharge state.

Optionally, the processing unit 720 may be further configured to: when the first energy storage rack does not meet the preset condition, keep the status of the first energy storage rack unchanged, and remain the weight of the first energy storage rack in the plurality of energy storage racks unchanged; or keep the status of the first energy storage rack unchanged, but reduce the weight of the first energy storage rack in the plurality of energy storage racks, until the first energy storage rack reaches the preset condition.

Optionally, the determining unit 710 is specifically configured to: when at least one of the following items is met, determine that a parameter of the first energy storage rack needs to be calibrated: An accumulated ampere-hour value is greater than or equal to a fifth preset threshold; or a time period since last parameter calibration is greater than or equal to a sixth preset threshold; or an accumulated charging energy value is greater than or equal to a seventh preset threshold; or an accumulated discharging energy value is greater than or equal to an eighth preset threshold.

For example, each unit in the apparatus 700 may be configured to implement a corresponding procedure executed by the control apparatus in the parameter calibration method 300 for the energy storage rack. The determining unit 710 may be configured to implement S310 and S320 in the method 300 shown in FIG. 3, and is specifically configured to perform a corresponding procedure in FIG. 4. The processing unit 720 may be configured to implement S330 in the method 300, and is specifically configured to perform a corresponding procedure in FIG. 5. The calibration unit 730 may be configured to implement S340 in the method 300, and is specifically configured to perform a corresponding procedure in FIG. 6.

It should be understood that a specific process in which each unit performs the foregoing corresponding steps is described in detail in the foregoing method embodiments. For brevity, details are not described herein.

It should be further understood that the unit division in embodiments of this application is an example, and is merely logical function division. There may be another division manner in actual implementation. In addition, functional units in embodiments of this application may be integrated into one processor, or each of the units may exist alone physically, or two or more units are integrated into one unit. The integrated unit may be implemented in a form of hardware, or may be implemented in a form of a software functional unit.

This application further provides a computer program product. The computer program product includes a computer program (which may also be referred to as code or an instruction). When the computer program is run, a computer is enabled to perform the method in any one of the embodiments shown in FIG. 3 to FIG. 6.

This application further provides a computer-readable storage medium. The computer-readable storage medium stores a computer program (which may also be referred to as code or an instruction). When the computer program is run, the computer is enabled to perform the method according to any one of the embodiments shown in FIG. 3 to FIG. 6.

It should be understood that the processor in embodiments of this application may be an integrated circuit chip, and has a signal processing capability. In an implementation process, the steps in the foregoing method embodiments can be implemented by a hardware integrated logical circuit in the processor, or by using instructions in a form of software. The foregoing processor may be a general-purpose processor, a digital signal processor (digital signal processor, DSP), an application-specific integrated circuit (application specific integrated circuit, ASIC), a field programmable gate array (field programmable gate array, FPGA) or another programmable logic device, a discrete gate or a transistor logic device, or a discrete hardware component. The processor may implement or perform the methods, steps, and logical block diagrams that are disclosed in embodiments of this application. The general-purpose processor may be a microprocessor, or the processor may be any conventional processor or the like. The steps of the methods disclosed with reference to embodiments of this application may be directly performed and completed by a hardware decoding processor, or may be performed and completed by using a combination of hardware and software modules in the decoding processor. The software module may be located in a mature storage medium in the art, for example, a random access memory, a flash memory, a read-only memory, a programmable read-only memory, an electrically erasable programmable memory, or a register. The storage medium is located in the memory. The processor reads information in the memory and completes the steps in the foregoing methods in combination with hardware of the processor.

It may be understood that the memory in embodiments of this application may be a volatile memory or a nonvolatile memory, or may include both a volatile memory and a nonvolatile memory. The nonvolatile memory may be a read-only memory (read-only memory, ROM), a programmable read-only memory (programmable ROM, PROM), an erasable programmable read-only memory (erasable PROM, EPROM), an electrically erasable programmable read-only memory (electrically EPROM, EEPROM), or a flash memory. The volatile memory may be a random access memory (random access memory, RAM), which is used as an external cache. By way of example but not limitative description, many forms of RAMs are available, for example, a static random access memory (static RAM, SRAM), a dynamic random access memory (dynamic RAM, DRAM), a synchronous dynamic random access memory (synchronous DRAM, SDRAM), a double data rate synchronous dynamic random access memory (double data rate SDRAM, DDR SDRAM), an enhanced synchronous dynamic random access memory (enhanced SDRAM, ESDRAM), a synchlink dynamic random access memory (synchlink DRAM, SLDRAM), and a direct rambus random access memory (direct rambus RAM, DR RAM). It should be noted that the memory of the systems and methods described in this specification includes but is not limited to these and any memory of another proper type.

Terms such as "unit" and "module" used in this specification may be used to indicate computer-related entities, hardware, firmware, combinations of hardware and software, software, or software being executed.

A person of ordinary skill in the art may be aware that various illustrative logical blocks (illustrative logical block) and steps (step) described with reference to embodiments disclosed in this specification can be implemented by electronic hardware or a combination of computer software and electronic hardware. Whether the functions are performed by hardware or software depends on particular applications and design constraint conditions of the technical solutions. A person skilled in the art may use different methods to implement the described functions for each particular application, but it should not be considered that the implementation goes beyond the scope of this application. In the several embodiments provided in this application, it should be understood that the disclosed apparatus, device, and method may be implemented in other manners. For example, the foregoing apparatus embodiments are merely examples. For example, division into the units is merely logical function division and may be other division in actual implementation. For example, a plurality of units or components may be combined or integrated into another system, or some features may be ignored or not performed. In addition, the displayed or discussed mutual couplings or direct couplings or communications connections may be implemented through some interfaces. The indirect couplings or communications connections between the apparatuses or units may be implemented in electronic, mechanical, or another form.

The units described as separate parts may or may not be physically separate, and parts displayed as units may or may not be physical units, that is, may be located in one position, or may be distributed on a plurality of network units. A part or all of the units may be selected based on actual requirements to achieve the objectives of the solutions of embodiments.

In addition, functional units in embodiments of this application may be integrated into one processing unit, or each of the units may exist alone physically, or two or more units are integrated into one unit.

In the foregoing embodiments, all or a part of functions of functional units may be implemented by using software, hardware, firmware, or any combination thereof. When software is used to implement the embodiments, all or a part of the embodiments may be implemented in a form of a computer program product. The computer program product includes one or more computer instructions (programs). When the computer program instructions (programs) are loaded and executed on a computer, the procedure or functions according to embodiments of this application are all or partially generated. The computer may be a general-purpose computer, a dedicated computer, a computer network, or another programmable apparatus. The computer instructions may be stored in a computer-readable storage medium or may be transmitted from a computer-readable storage medium to another computer-readable storage medium. For example, the computer instructions may be transmitted from a website, computer, server, or data center to another website, computer, server, or data center in a wired (for example, a coaxial cable, an optical fiber, or a digital subscriber line (digital subscriber line, DSL)) or wireless (for example, infrared, radio, or microwave) manner. The computer-readable storage medium may be any usable medium accessible by the computer, or a data storage device, for example, a server or a data center, integrating one or more usable media. The usable medium may be a magnetic medium (for example, a floppy disk, a hard disk, or a magnetic tape), or an optical medium (for example, a digital versatile disc (digital video disc, DVD)), a semiconductor medium (for example, a solid-state disk (solid state disk, SSD)), or the like.

When the functions are implemented in the form of a software functional unit and sold or used as an independent product, the functions may be stored in a computer-readable storage medium. Based on such an understanding, the technical solutions of this application essentially, or the part contributing to the conventional technology, or some of the technical solutions may be implemented in the form of a software product. The computer software product is stored in a storage medium and includes several instructions for instructing a computer device (which may be a personal computer, a server, or a network device) to perform all or a part of the steps of the methods described in embodiments of this application. The foregoing storage medium includes any medium that can store program code, such as a USB flash drive, a removable hard disk, a ROM, a RAM, a magnetic disk, or an optical disc.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. An energy storage system, comprising a control apparatus and one or more battery sub-arrays, wherein each of the one or more battery sub-arrays comprises one or more energy storage racks, and each of the one or more energy storage racks comprises one or more battery packs; the control apparatus is configured to:
determine that parameter calibration needs to be performed on a first energy storage rack in a first battery sub-array of the one or more battery sub-arrays;
when the first energy storage rack meets a preset condition, increase a weight of the first energy storage rack in the first battery sub-array, wherein the weight is a weight of a charge power of the first energy storage rack in a charge state to a total charge power of the first battery sub-array, or a weight of a discharge power of the first energy storage rack in a discharge state to a total discharge power of the first battery sub-array; and
after each battery pack in the first energy storage rack is fully charged or remaining power of the battery pack is fully discharged, perform calibration on a parameter of the battery pack.

2. The energy storage system according to claim 1, wherein when the first energy storage rack is in a discharge state, the preset condition comprises:
a percentage of a state of energy of the first energy storage rack is less than a first preset threshold; or
a percentage of a state of energy of the first energy storage rack is greater than or equal to a first preset threshold, but the first energy storage rack receives a charge instruction; or
a duration in which the first energy storage rack is in a discharge state is greater than a second preset threshold.

3. The energy storage system according to claim 1, wherein when the first energy storage rack is in a charge state, the preset condition comprises:
a percentage of a state of energy of the first energy storage rack is greater than a third preset threshold; or
a percentage of a state of energy of the first energy storage rack is less than or equal to a third preset threshold, but the first energy storage rack receives a discharge instruction; or
a duration in which the first energy storage rack is in a charge state is greater than a fourth preset threshold.

4. The energy storage system according to any one of claims 1 to 3, wherein the control apparatus comprises a sub-array control unit and one or more battery control units BCUs, and each BCU corresponds to an energy storage rack, wherein
a first BCU corresponding to the first energy storage rack is configured to determine that parameter calibration needs to be performed on the first energy storage rack, and is configured to send a calibration request to the sub-array control unit, wherein the calibration request is used for requesting to perform parameter calibration on the first energy storage rack; and
in response to the calibration request, the sub-array control unit determines a first power adjustment value of the first energy storage rack when the first energy storage rack meets the preset condition, to increase the weight of the first energy storage rack in the first battery sub-array; and sends a first power adjustment instruction to the first BCU, wherein the first power adjustment instruction carries the first power adjustment value.

5. The energy storage system according to claim 4, wherein the sub-array control unit is further configured to: when the first energy storage rack does not meet the preset condition, determine a second power adjustment value of the first energy storage rack, to reduce the weight of the first energy storage rack in the first battery sub-array; and send a second power adjustment instruction to the first BCU, wherein the second power adjustment instruction carries the second power adjustment value.

6. The energy storage system according to any one of claims 1 to 3, wherein the control apparatus comprises a sub-array control unit and one or more battery control units BCUs, and each BCU corresponds to an energy storage rack, wherein
a first BCU corresponding to the first energy storage rack is configured to determine that parameter calibration needs to be performed on the first energy storage rack, and is configured to: when the first energy storage rack meets the preset condition, send a first weight adjustment request to the sub-array control unit, wherein the first weight adjustment request is used for requesting to increase the weight of the first energy storage rack in the first battery sub-array; and
the sub-array control unit determines a first power adjustment value of the first energy storage rack in response to the first weight adjustment request, to increase the weight of the first energy storage rack in the first battery sub-array; and sends a first power adjustment instruction to the first BCU, wherein the first power adjustment instruction carries the first power adjustment value.

7. The energy storage system according to claim 6, wherein the first BCU is further configured to: when the first energy storage rack does not meet the preset condition, send a second weight adjustment request to the sub-array control unit, wherein the second weight adjustment request is used for requesting to reduce the weight of the first energy storage rack in the first battery sub-array; and
the sub-array control unit determines a second power adjustment value of the first energy storage rack in response to the second weight adjustment request, to reduce the weight of the first energy storage rack in the first battery sub-array; and send a second power adjustment instruction to the first BCU, wherein the second power adjustment instruction carries the second power adjustment value.

8. The energy storage system according to any one of claims 4 to 7, wherein the control apparatus further comprises one or more battery monitor units BMUs, and each BMU corresponds to a battery pack; and
each BMU corresponding to each battery pack in the first energy storage rack is configured to perform calibration on a parameter of the corresponding battery pack after the corresponding battery pack is fully charged or remaining power of the corresponding battery pack is fully discharged.

9. The energy storage system according to claim 8, wherein
a first BMU in the one or more BMUs is further configured to determine, based on one or more of the following items, that a parameter of a first battery pack in the first energy storage rack needs to be calibrated: an accumulated ampere-hour value is greater than or equal to a fifth preset threshold; or
a time period since last parameter calibration is greater than or equal to a sixth preset threshold; or
an accumulated charging energy value is greater than or equal to a seventh preset threshold; or
an accumulated discharging energy value is greater than or equal to an eighth preset threshold.

10. The energy storage system according to any one of claims 1 to 9, wherein
the control apparatus is further configured to determine a status of the first energy storage rack, wherein the status comprises a charge state or a discharge state.

11. A parameter calibration method, applied to an energy storage system, wherein the energy storage system comprises one or more battery sub-arrays, each of the one or more battery sub-arrays comprises one or more energy storage racks, each of the one or more energy storage racks comprises one or more battery packs, and the method comprises:
determining that parameter calibration needs to be performed on a first energy storage rack, wherein the first energy storage rack is an energy storage rack in a first battery sub-array of the one or more battery sub-arrays;
when the first energy storage rack meets a preset condition, increasing a weight of the first energy storage rack in the first battery sub-array; and
after each battery pack in the first energy storage rack is fully charged or remaining power of the battery pack is fully discharged, performing calibration on a parameter of the battery pack.

12. The method according to claim 11, wherein when the first energy storage rack is in a discharge state, the preset condition comprises:
a percentage of a state of energy of the first energy storage rack is less than a first preset threshold; or
a percentage of a state of energy of the first energy storage rack is greater than or equal to a first preset threshold, but the first energy storage rack receives a charge instruction; or
a duration in which the first energy storage rack is in a discharge state is greater than a second preset threshold.

13. The method according to claim 11, wherein when the first energy storage rack is in a charge state, the preset condition comprises:
a percentage of a state of energy of the first energy storage rack is greater than a third preset threshold; or
a percentage of a state of energy of the first energy storage rack is less than or equal to a third preset threshold, but the first energy storage rack receives a discharge instruction; or
a duration in which the first energy storage rack is in a charge state is greater than a fourth preset threshold.

14. The method according to any one of claims 11 to 13, wherein the method further comprises:
when the first energy storage rack does not meet the preset condition, keeping a status of the first energy storage rack unchanged, and keeping the weight of the first energy storage rack in the plurality of energy storage racks unchanged; or keeping a status of the first energy storage rack unchanged, but reducing the weight of the first energy storage rack in the plurality of energy storage racks, until the first energy storage rack reaches the preset condition.

15. The method according to any one of claims 11 to 14, wherein the method further comprises:
determining a status of the first energy storage rack, wherein the status comprises a charge state or a discharge state.
